# EUROPÄISCHE PATENTSCHRIFT

(11) **EP 0 233 474 B1**
(45) Veröffentlichungstag und Bekanntmachung des Hinweises auf die Patenterteilung: **02.06.1993**
(21) Anmeldenummer: 87100493.3
(22) Anmeldetag: 16.01.1987
(51) Int. Cl.: H03M 1/30, G01P 3/48

(54) **Vorrichtung zur Ermittlung der Drehzal einer Welle**
Device for determining the number of revolutions of a shaft
Dispositif de détermination du nombre de tours d'un arbre

(30) Priorität: 17.02.1986 DE 3604903
(43) Veröffentlichungstag der Anmeldung: 26.08.1987
(73) Patentinhaber: ROBERT BOSCH GMBH, 70442 Stuttgart (DE)
(72) Erfinder: Fiebig, Arnim, El.-Ing., D-7022 Leinfelden-Echterdingen (DE); Baur, Hans Joachim, Dipl.-Ing., D-7022 Leinfelden-Echterdingen (DE)

(56) Entgegenhaltungen:
- ELECTRONICS LETTERS, Band 7, Nr. 12, 17. Juni 1971, Seiten 345-346, Stevenage, GB; T.H. THOMAS: "Rapid pulse-frequency-number convertor"
- PATENT ABSTRACTS OF JAPAN, Band 8, Nr. 282 (P-323)[1719], 22. Dezember 1984; & JP-A-59 148 810 (MATSUSHITA DENKI SANGYO K.K.) 25-08-1984
- PATENT ABSTRACTS OF JAPAN, Band 7, Nr. 48 (P-178)[1193], 24. Februar 1983; & JP-A-57 196 167 (SHIN NIPPON DENKI K.K.) 02-12-1982
- ELECTRONICS, Band 41, Nr. 11, 27. Juni 1968, Seiten 123-126, New York, US; J.L. WEST: "Two-step process speeds low-frequency measurements"

## Beschreibung

### Stand der Technik

Die Erfindung geht aus von einer Vorrichtung zur Ermittlung der Drehzahl nach der Gattung des Hauptanspruchs. Vorrichtungen zur Ermittlung der Drehzahl sind bereits allgemein bekannt. Hierbei finden meist sogenannte Inkrementgeber oder Segmentgeber Verwendung. Bei Inkrementgebern weist beispielsweise die Welle ein Zahnrad auf, auf dem eine Vielzahl von Zähnen angebracht ist. Zur Ermittlung der Drehzahl wird die Zeit bestimmt, bis eine bestimmte Anzahl von Zähnen den Impulsgeber passiert hat. Die dabei gemessene Zeit ist ein Maß für die Drehzahl. Weiterhin wird zur Ermittlung der Drehzahl bei Inkrementsystemen auch festgestellt, wieviel Zähne innerhalb einer vorgegebenen Zeit den Impulsgeber passiert haben. Auch die Zahl der Zähne ist dann ein Maß für die Drehzahl. Bei Segmentgebern wird die Zeit bestimmt, die benötigt wird, bis das Segment den Impulssensor passiert hat. Bei den vorbekannten Verfahren zur Erfassung der Drehzahl einer Welle ist die Wahl der Zeitkonstante kritisch. Bei kleinen Drehzahlen kann sie zum Beispiel bei Segmentsystemen relativ klein gewählt werden, was jedoch bei hohen Drehzahlen eine geringe Auflösung bedingt. Sollen hohe Drehzahlen erfaßt werden, so ist die Zeitkonstante relativ groß zu wählen, was für kleine Drehzahlen oft zu groß ist. Die bekannten Vorrichtungen zur Ermittlung der Drehzahl sind daher nur für einen kleinen, relativ begrenzten Drehzahlbereich optimal auslegbar.

### Vorteile der Erfindung

Die erfindungsgemäße Vorrichtung mit den kennzeichnenden Merkmalen des unabhängigen Anspruchs hat demgegenüber den Vorteil, daß die Zeitkonstante zur Erfassung der Drehzahl selbst drehzahlabhängig ist. Dadurch wird einerseits erreicht, daß in allen Drehzahlbereichen eine kleine Zeitkonstante gegeben ist und andererseits eine genaue Drehzahlerfassung und Auswertung in einem weiten Drehzahlbereich möglich ist.

Durch die in den abhängigen Ansprüchen aufgeführten Maßnahmen sind vorteilhafte Weiterbildungen und Verbesserungen der im Hauptanspruch angegebenen Vorrichtung möglich. Besonders vorteilhaft ist, die Zeitglieder als Zählmittel auszubilden, die von einem vorgegebenen Zählerstand auf einen weiteren vorgegebenen Zählerstand nach ihrer Auslösung zählen. Durch diese Maßnahme wird eine besonders einfache Korrektur der drehzahlabhängigen Zeitkonstante möglich, wobei es prinzipiell gleichgültig ist, ob der untere Zählerstand und/oder der obere Zählerstand oder beide zur Bestimmung der Zeitkonstante verändert wird. Besonders einfach gestaltet sich die Bildung der Zeit dann, wenn ein Zählerstand als Null gewählt wird und der andere Zählerstand in Abhängigkeit vom vorangegangenen Drehzahlwert verändert wird.

Die Aufwärts/Abwärts-Zählmittel werden nur Erzielung einer großen Auflösung zweckmäßigerweise mit einem Takt gespeist, der vom vorhergehenden Zählergebnis abhängt. Dadurch wird erreicht, daß die erfindungsgemäße Vorrichtung zur Ermittlung der Drehzahl ein gutes Dynamikverhalten aufweist und schnell eventuellen Drehzahlveränderungen folgen kann, wobei die Genauigkeit erhalten bleibt. Die Zählerstände werden zweckmäßigerweise in einem Speicher, vorzugsweise einem Latch, zwischengespeichert. Weitere vorteilhafte Ausgestaltung der Erfindung ergeben sich aus der Beschreibung in Verbindung mit der Zeichnung.

### Zeichnung

Ein Ausführungsbeispiel der Erfindung ist in der Zeichnung dargestellt und in der nachfolgenden Beschreibung näher erläutert. Es zeigen Figur 1 ein Blockschaltbild der Erfindung, Figur 2 ein Diagramm zur Erläuterung der Funktionsweise des Blockschaltbildes und Figur 3 ein weiteres Diagramm bei einer anderen Drehzahl.

### Beschreibung des Ausführungsbeispiels

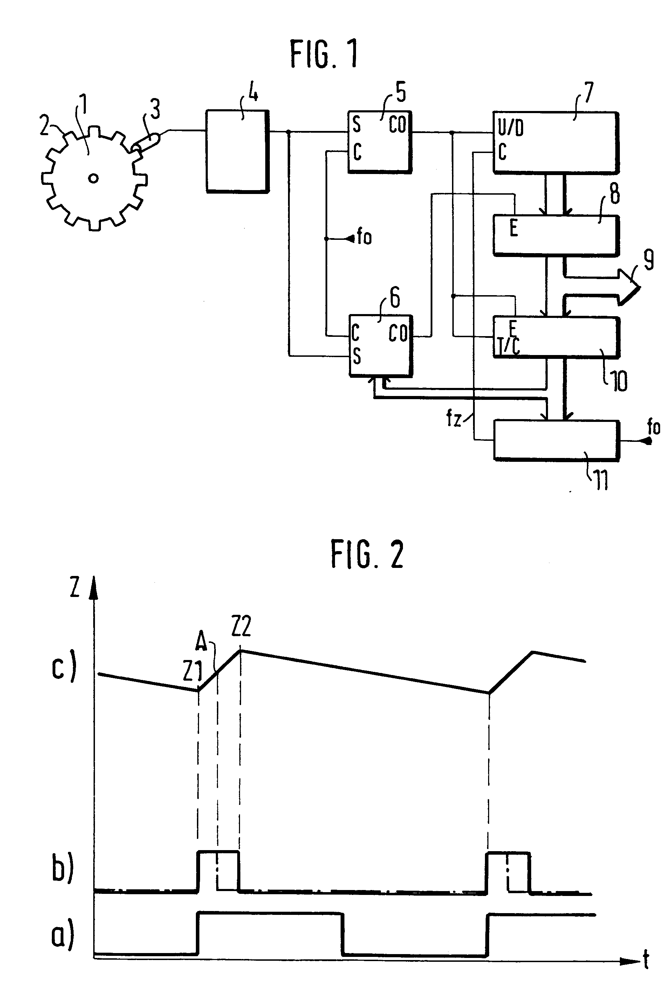

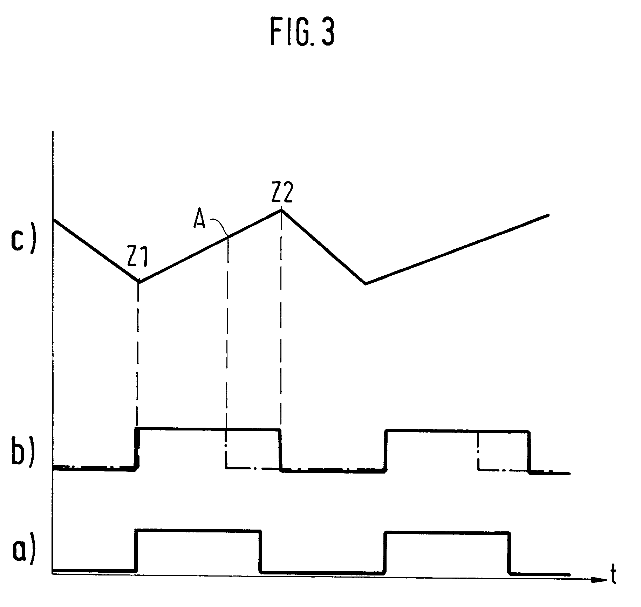

Die Figur 1 zeigt ein auf einer nicht dargestellten Welle angebrachtes Zahnrad 1, das sich mit der Welle dreht. Das Zahnrad 1 weist Zähne 2 auf, gegenüber denen ein Impulssensor 3 angebracht ist. Der Impulssensor 3 liefert bei jedem Zahn einen Impuls, wie er in Figur 2a und 3a symbolisch dargestellt ist. Das Ausgangssignal des Impulssensors 3 wird einer Impulsformerstufe 4 zugeführt, die lediglich dazu dient, die meist verschliffenen Signale des Impulssensors 3 in Rechtecksignale gemäß Figur 2a und 3a umzuwandeln. Der Ausgang des Impulsformers 4 steht mit jeweils einem Starteingang eines Zählers 5 und eines Zählers 6 in Verbindung. Die Zähler 5 und 6 weisen noch Takteingänge C auf, die von der Frequenz fo eines Taktgenerators gespeist werden. Bei der Frequenz fo handelt es sich um eine sehr hohe Frequenz, die wesentlich höher ist, als die Frequenz, die bei der höchsten Drehzahl durch den Impulssensor 3 erzeugt wird. Der Überlaufausgang CO des Zählers 5 ist mit dem Aufwärts/Abwärts-Steuereingang U/D eines Zählers 7 verbunden. Des weiteren führt eine Leitung vom Überlaufausgang CO des Zählers 5 zum Übernahmeeingang E des Latch 10 sowie zu seinem Komplementeingang T/C. Der Überlaufausgang CO des Zählers 6 steht mit dem Übernahmeeingang E des Latch 8 in Verbindung.

Der Ausgang des Zählers 7 ist über eine Datenleitung mit dem Latch 8 verbunden. Der Ausgang des Latches 8 führt zu dem Eingang eines weiteren Latch 10. Dazwischen ist eine Datenleitung 9 angeschlossen, an der das digitale Drehzahlergebnis abgreifbar ist. Weiterhin führt eine Datenleitung vom Ausgang des Latch 10 zu einem digitalen Rate Multiplier 11. Der digitale Rate Multiplier 11 weist einen Takteingang C auf, an dem die Taktfrequenz fo anliegt. Der digitale Rate Multiplier multipliziert die Taktfrequenz 11 mit dem am Ausgang des Latches 10 anliegenden Wert. Der Ausgangswert des Latches 10 steht des weiteren mit einem Setzeingang des Zählers 6 in Verbindung.

Für die Zähler 5, 6 und 7 eignet sich beispielsweise der setzbare Aufwärts/Abwärts-Zähler C/D 4029 der Firma Motorola. Der Setzeingang wird dabei von den Zählern 5 und 7 nicht benötigt, während die Zähler 5 und 6 von der Umschaltung von Aufwärts auf Abwärts keinen Gebrauch machen. Als digitaler Rate Multiplier 11 eignet sich beispielsweise der digitale Rate Multiplier CD 4089 der Firma Motorola. Der Taktausgang des digitalen Rate Multipliers steht im übrigen mit dem Takteingang C des Zählers 7 in Verbindung.

Die Wirkungsweise der Schaltungsanordnung gemäß Figur 1 sei anhand der Figuren 2 und 3 näher erläutert. Die Zähler 5 und 6 sind Zeitglieder, die gemäß Figur 2b und 3b bei jedem positiven Impuls des Impulssensors 3 durch den Starteingang S gesetzt werden. Hierbei wirken die Zähler 5 und 6 als Zeitglieder. Während der Zähler 5 auf einen festen Zählerstand gesetzt ist, ist der Zählerstand beim Zähler 6 zum Startzeitpunkt variabel. Der Zählerstand des Zählers 6 ist jedoch immer kleiner als der Zählerstand des Zählers 5, so daß die Zeitdauer des Zählers 6 bis zu seinem Überlauf immer kürzer ist als die des Zählers 5. Durch die Taktimpulse fo wird nun der Zähler 5 und der Zähler 6 von dem vorgegebenen Wert bis zu dem Zeitpunkt herabgezählt, bis ein Überlauf bei den Zählern 5 und 6 auftritt. Wie die Figuren 2b und 3b zeigen, wirken die Zähler 5 und 6 wie Zeitglieder, die beim Auftreten eines Überlaufs, d.h. wenn auf den Wert Null herabgezählt worden ist, von einer logischen 1, auf die sie beim Start gesetzt worden sind, auf eine logische Null zurückgesetzt werden. Beim Rücksetzen von einer logischen eins auf eine logische Null (Zeitpunkt A) wird durch den Zähler 6 das Latch 8 aktiviert, das den augenblicklichen im Zähler 7 vorhandenen Zahlenwert in das Latch übernimmt. Dieser Zahlenwert steht am Ausgang des Latches 8 zur Verfügung und ist ein Maß für die Drehzahl der Welle. Zu einem späteren Zeitpunkt, der durch das Zeitglied mit dem Zähler 5 bestimmt ist, wird der Zähler 7 über seinen Eingang U/D von Aufwärtszählen auf Abwärtszählen geschaltet. Gleichzeitig übernimmt das Latch 10 den im Latch 8 gespeicherten Wert, und schaltet vom Komplement auf den wahren, neu übernommenen Wert um.

In Abhängigkeit von dem in Latch 10 gespeicherten Wert wird der Zähler 6 gesetzt bzw. der Multiplier 11 angesteuert. Ist der in das Latch 10 übernommene Wert groß (hohe Drehzahl), so bedeutet dies, daß der Zähler 6 eine relativ lange Zeit benötigt, um seinen Wert Null zu erreichen. Der in Figur 2 dargestellte Schaltpunkt A des Zählers 6 verschiebt sich daher näher an den Zeitpunkt (Z2), an dem der Zähler 6 schaltet und der Zähler 7 von Vorwärtszählen auf Rückwärtszählen umgeschaltet wird. Figur 3 zeigt daher den Fall, bei dem eine hohe Drehzahl gemessen wird. Demgegenüber bewirkt eine relativ kleine gespeicherte Zahl (niedrige Drehzahl) im Latch 10, daß der Zeitpunkt A, bei dem der Zähler 6 schaltet, näher zum Zeitpunkt Z1 verschoben ist. Der Übernahmezeitpunkt für das Latch 8 ist daher drehzahlabhängig, er wird bei kleinen Drehzahlen, d.h. bei niedrigen Zählerständen des Zählers 7 näher bei Z1 liegen, während er mit steigender Drehzahl zum Wert Z2 läuft.

Das Abwärtszählen des Zählers mit der Zählfrequenz fz ist ebenfalls dadurch bestimmt, welcher Wert in das Latch 10 übernommen wurde. Ist dieser Wert hohe, so wird auch die Rückwärtszählfrequenz hoch sein. Ist der Wert niedrig, so wird die Rückwärtszählfrequenz ebenfalls niedrig sein.

Zu Betrachten bleiben noch die Vorgänge, die nach dem Auftreten eines Startimpulses während des Aufwärtszählens des Zählers 7 stattfinden. Nach diesem Zeitpunkt ist, wie bereits oben erwähnt, am Ausgang des Latch 10 das Komplement des in das Latch 10 übernommenen Wertes angelegt. Maßgebend für den Hochzählvorgang ist daher der Wert, der im Latch 8 im vorhergehenden Zyklus abgespeichert ist. Ist dieser Wert niedrig gewesen, so ist das Komplement hoch, d.h. das Hochzählen wird sehr schnell von statten gehen. Ist der in das Latch 8 übernommene Wert hoch, so wird das vom Latch 10 ausgegebene Komplement sehr niedrig sein, so daß der Hochzählvorgang im Zähler 7 sehr langsam von statten geht. Für den Zähler 6 spielt der Komplementwert im Latch 10 keine Rolle, da mit Beginn des Startsignals der bereits im Latch 10 eingespeicherte wahre Wert in den Zähler 6 übernommen wurde. Der Hochzählvorgang findet nunmehr in der durch das Zeitglied 5 vorgegebenen Zeitdauer statt und der Zähler 7 läuft vom Zählerstand Z1 zum Zählerstand Z2. Im Endeffekt ergibt sich der in den Figuren 2c und 3c dargestellt Verlauf im Zähler 7, wobei der zum Zeitpunkt A abgegriffene Wert ein direktes Maß für die Drehzahl ist.

Durch die so ausgebildete Vorrichtung wird erreicht, daß auch sehr kleine Drehzahlen (hohe Zählfrequenz fz) sicher erfaßt werden können. Günstig ist auch, daß auch kleine Zeitkonstanten gegeben sind, so daß die erfaßte Drehzahl sehr schnell zur Verfügung steht. Ein Vergleich zwischen den Figuren 2a und 2b bzw. 3a und 3b zeigt, daß für die Erfassung der Drehzahl nur ein Bruchteil der Zeit benötigt wird, die zwischen zwei Zähnen zur Verfügung steht.

Die vorgeschlagene Vorrichtung zur Erfassung der Drehzahl ist für verschiedene Zweck einsetzbar. Das an der Leitung 9 anstehende digitale Ausgangssignal kann beispielsweise für Steuergeräte von Brennkraftmaschinen ebenso Verwendung finden, wie zur Drehzahlregelung von Elektromotoren beispielsweise bei elektrischen Werkzeugen. Die einfache elektronischen Beschaltung macht es weiterhin möglich, die gesamte Schaltungsanordnung softwaremäßig in Mikroprozessoren zu realisieren, wobei dann die Zähl- und Zeitvorgänge im Rechner selbst realisiert sind.

## Patentansprüche

1. Vorrichtung zur Ermittlung der Drehzahl einer sich drehenden Welle mit auf der Welle angebrachten Impulsauslösern und mit wenigstens einem fest angeordneten, den Impulsauslösern gegenüberstehenden Sensor, dadurch gekennzeichnet, daß das Sensorsignal zwei Zeitgliedern (5, 6) zugeführt ist, wobei das erste Zeitglied (5) eine feste Zeitkonstante aufweist, die kleiner als die Periodendauer des Sensorsignals ist, die aber länger als die Zeitkonstante des zweiten Zeitgliedes (6) ist, daß durch das Ausgangssignal des zweiten Zeitgliedes (6) der Zählerstand eines Aufwärts/Abwärts-Zählers (7) als Maß für die Drehzahl abrufbar ist, wobei das Aufwärts- und Abwärtszählen in Zählperioden erfolgt, deren Dauer mit der Periodendauer, des Sensorsignales übereinstimmt und wobei der Takt des Zählers (7) beim Aufwärtszählen vom Komplement des in der jeweils vorhergehenden Zählperiode ermittelten Zählerstandes und beim Abwärtszählen vom wahren Wert des in der aktuellen Zählperiode ermittelten Zählerstandes bestimmt wird, daß durch das Ausgangssignal des ersten Zeitgliedes (5) die Zählrichtung des Zählers (7) umschaltbar ist und daß die Zeitkonstante des zweiten Zeitgliedes (6) durch das in der vorhergehenden Zählperiode abgerufene Zählergebnis bestimmt ist.

2. Vorrichtung nach Anspruch 1, dadurch gekennzeichnet, daß die Zeitglieder (5, 6) als Zähler ausgebildet sind, die nach ihrer Auflösung von einem vorgegebenen Zählerstand auf einen weiteren vorgegebenen Zählerstand zählen.

3. Vorrichtung nach einem der vorherigen Ansprüche, dadurch gekennzeichnet, daß der abgerufene Zählerstand in mindestens einem Latch (8, 10) zwischengespeichert wird.

## Claims

1. Device for establishing the speed of a rotating shaft, having pulse triggers mounted on the shaft and having at least one fixedly arranged sensor opposite the pulse triggers, characterised in that the sensor signal is fed to two timers (5, 6), the first timer (5) having a fixed time constant which is smaller than the period of the sensor signal but longer than the time constant of the second timer (6), in that the counter reading of an up-counter/down-counter (7) can be called up as a measure of the speed by means of the output signal of the second timer (6), the upward and downward counting being performed in counting periods whose duration conforms with the period of the sensor signal, and the cycle of the counter (7) being determined during upwards counting by the complement of the counter reading established in the respectively preceding counting period and being determined during downwards counting by the true value of the counter reading established in the current counting period, in that the counting direction of the counter (7) can be switched by the output signal of the first timer (5), and in that the time constant of the second timer (6) is determined by the counting result called up in the preceding counting period.

2. Device according to Claim 1, characterised in that the timers (5, 6) are constructed as counters which after being triggered by a prescribed counter reading count to a further prescribed counter reading.

3. Device according to one of the preceding claims, characterised in that the called-up counter reading is intermediately stored in at least one latch (8, 10).

## Revendications

1. Dispositif pour détecter la vitesse de rotation d'un arbre en rotation avec des déclencheurs d'impulsions disposés sur l'arbre et avec au moins un détecteur disposé de façon fixe, situé en regard des déclencheurs d'impulsions, dispositif caractérisé en ce que le signal du détecteur est envoyé à deux systèmes temporisés (5, 6), le premier système temporisé (5) présentant une constante de temps fixe, qui est plus petite que la durée de période du signal du détecteur, mais qui est plus longue que la constante de temps du deuxième système temporisé (6), en ce que l'on peut prélever comme mesure de la vitesse de rotation la position d'un compteur croissant-décroissant (7) grâce au signal de sortie du deuxième système temporisé (6), tandis que le comptage croissant et décroissant a lieu dans des périodes de comptage dont la durée coïncide avec la durée de période du signal du détecteur et que l'impulsion du compteur (7) est déterminée lors du comptage croissant par le complément de la position du compteur détectée au cours de la période de comptage précédente et lors du comptage à rebours par la vraie valeur de la position du compteur détectée au cours de la période actuelle de comptage, si bien que l'on peut inverser à l'aide du signal de sortie du premier système temporisé (5) le sens du comptage et que la constante de temps du deuxième système temporisé (6) est déterminée par le résultat du compteur prélevé au cours de la période de comptage précédente.

2. Dispositif selon la revendication 1, caractérisé en ce que les systèmes temporisés (5, 6) sont constitués comme des compteurs, qui comptent depuis une position de compteur prédéfinie jusqu'à une autre position de compteur prédéfinie après leur déclenchement.

3. Dispositif selon l'une des revendications précédentes, caractérisé en ce que la position de compteur prélevée est stockée temporairement dans au moins un verrou (8, 10).
